# EUROPÄISCHE PATENTSCHRIFT

(11) **EP 0 863 608 B1**
(45) Veröffentlichungstag und Bekanntmachung des Hinweises auf die Patenterteilung: **23.03.2005**
(21) Anmeldenummer: 97120513.3
(22) Anmeldetag: 22.11.1997
(51) Int. Cl.: H03F 3/72, H03G 1/00

(54) **Schaltbarer Hochfrequenzverstärker**
Switchable high frequency amplifier
Amplificateur à haute fréquence à gain commutable

(30) Priorität: 05.03.1997 DE 19708839
(43) Veröffentlichungstag der Anmeldung: 09.09.1998
(73) Patentinhaber: ROBERT BOSCH GMBH, 70442 Stuttgart (DE)
(72) Erfinder: Mader, Thomas, 31139 Hildesheim (DE); Kottschlag, Gerhard, 31139 Hildesheim (DE); Pitz, Gerhard, 31139 Hildesheim (DE); Mevissen, Walter, 40227 Düsseldorf (DE)

(56) Entgegenhaltungen:
- DD-A- 212 146
- GB-A- 2 219 702
- US-A- 3 984 783
- US-A- 5 399 927
- PATENT ABSTRACTS OF JAPAN vol. 010, no. 332 (E-453), 12.November 1986 & JP 61 137410 A (MITSUBISHI ELECTRIC CORP), 25.Juni 1986,

## Beschreibung

### Stand der Technik

Die Erfindung geht aus von einer Schaltung für einen Verstärker, wobei der Verstärker ein Hochfrequenzsignal verstärkt, nach der Gattung des Hauptanspruchs.

Aus dem Stand der Technik sind Schaltungen für Verstärker von Hochfrequenzsignalen bekannt, die eine Steuerung des Verstärkungsfaktors des Verstärkers ermöglichen. Eine besonders einfache Realisierung erzielt man dabei durch das Ein- bzw. Ausschalten des Verstärkers selbst. Dies erfolgt durch Anlegen oder Abschalten einer Betriebsspannung. Die Verstärker weisen aber je nach Schaltzustand unterschiedliche Wellenwiderstände an ihren Ein- und/oder Ausgängen auf.

### Vorteile der Erfindung

Die erfindungsgemäße Schaltung für einen Verstärker mit den kennzeichnenden Merkmalen des Hauptanspruchs hat demgegenüber den Vorteil, daß durch eine zum Verstärker parallel geschaltete Diode eine Anpassung des Wellenwiderstands der Schaltung für die beiden Schaltzustände des Verstärkers erreicht wird. Dadurch, daß die Wellenwiderstände in den beiden Schaltzuständen nahezu gleich sind, wird die Anpassung angeschlossener Schaltungsteile an den Verstärker vereinfacht. Die Optimierung der Gesamtverstärkung und/oder des Rauschverhaltens der Gesamtschaltung muß nicht mehr unter Berücksichtigung mehrerer Schaltzustände des Verstärkers erfolgen. Besonders bei Verbindung des Verstärkers mit Filterelementen bleibt deren Selektionsfähigkeit vor und hinter dem Verstärker in allen Betriebszuständen voll erhalten.

### Zeichnung

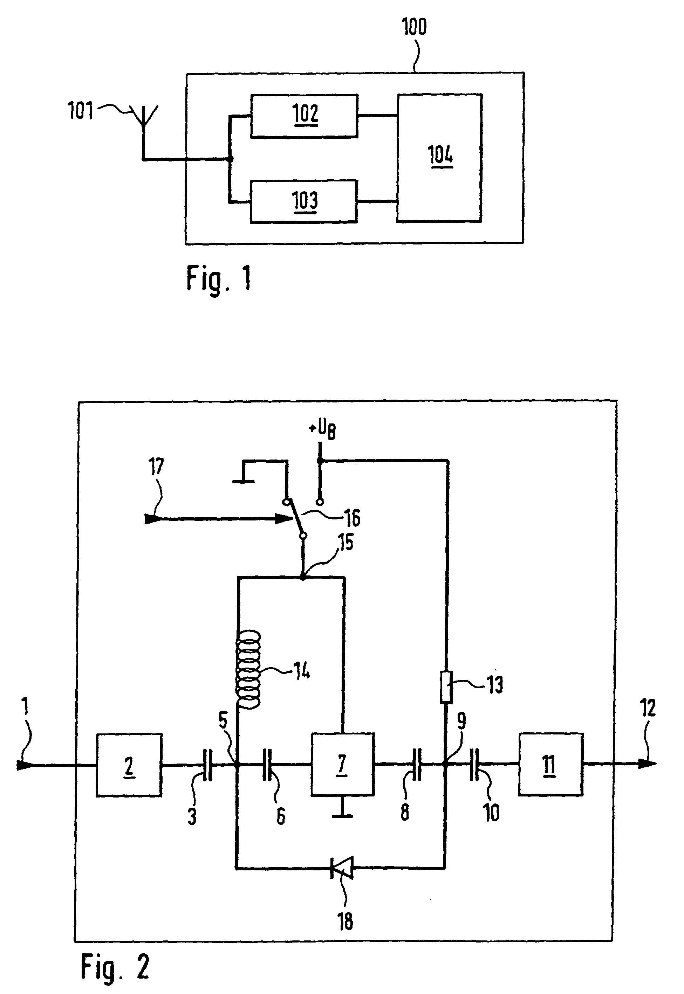

Ein Ausführungsbeispiel der Erfindung ist in der nachstehenden Zeichnung dargestellt und in der nachfolgenden Beschreibung näher erläutert. Es zeigt Figur 1 ein Funktelefongerät, und Figur 2 die erfindungsgemäße Verstärkerschaltung.

### Beschreibung des Ausführungsbeispiels

Figur 1 stellt einen Funk-Sende/Empfänger 100 dar. Der Funk-Sende/Empfänger 100 weist eine Antenne 101 auf, die sowohl mit einer Empfängereinheit 102, als auch mit einer Sendeeinheit 103 verbunden ist. Sowohl Sendeeinheit 103 als auch Empfängereinheit 102 sind mit einem Niederfrequenzteil 104 verbunden. Die Antenne 101 wird dazu verwendet, Radiofrequenzsignale auszusenden und diese zu empfangen. Bei Empfang von Signalen wandelt die Antenne 101 die Signale in elektrische Hochfrequenzsignale um und überträgt sie an die Empfängereinheit 102. Die Empfängereinheit 102 demoduliert elektrische Hochfrequenzsignale und führt sie dem Niederfrrequnezteil 104 zu. Bei der Übertragung von Hochfrequenzsignalen führt das Niederfrequenzteil 104 der Sendeeinheit 103 Informationen zu, die übertragen werden sollen. Die Sendeeinheit 103 nimmt die Infromationen an, wandelt sie in elektrische Hochfrequenzsignale und verstärkt die elektrischen Hochfrequenzsignale. Die Antenne 101 sendet sie in die Umgebung ab.

Figur 2 zeigt die Schaltung eines Verstärkers, wie er z.B. im Sender 102 oder im Empfänger 103 angeordnet werden kann. Über den Eingang 1, der mit einem ersten Filter 2 verbunden ist, wird über einen ersten Kondensator 3, einen ersten Koppelpunkt 5 und einen zweiten Kondensator 6 die Verbindung an den Eingangsanschluß des Verstärkers 7 hergestellt. Der Ausgang des Verstärkers 7 ist mit einem dritten Kondensator 8, einem zweiten Koppelpunkt 9, einem vierten Kondensator 10, sowie einem Filter 11 verbunden. Der Ausgang 12 des Filters 11 ist mit weiteren Bauteilen des Senders oder des Empfängers verbunden. Der Betriebsspannungseingang des Verstärkers 7 ist über den dritter Koppelpunkt 15 mit einem Schalter 16, und über den Schalter 16 mit dem Bezugspotential oder der Betriebsspannung U_{B} verbunden. Zwischen dem ersten Koppelpunkt 5 und dem zweiten Koppelpunkt 9 ist eine Diode 18 in Sperrichtung parallel zum Verstärker eingebaut. Die Diode 18 ist über den zweiten Koppelpunkt 9 und einen Widerstand 13 mit der Betriebsspannung U_{B} verbunden. Über den ersten Koppelpunkt 5 und eine Spule 14 wird die Verbindung zwischen Diode 18 und dem dritter Koppelpunkt 15 hergestellt, der eine Schaltung auf das Bezugspotential oder die Betriebsspannung U_{B} ermöglicht. Über den Betriebseingang 17 wird der Schalter 16 geschaltet.

Der Verstärker 7 wird von dem Steuersignal, das über die Leitung 17 zugeführt wird, ein- und ausgeschaltet. Das Steuersignal schaltet den Verstärker beispielsweise bei einem Empfänger immer dann ein, wenn in nachfolgenden Stufen der Schaltung eine zu geringe Signalstärke auf der Leitung 12 detektiert wurde. Es ist aber auch möglich, daß bei einem Sender der Befehl zur Aussendung einer höheren Leistung von der Basisstation kommt. Der Verstärker 7 wird in Abhängigkeit von dem Steuersignal zeitweise mit der Betriebsspannung U_{B} versorgt oder mit dem Bezugspotential verbunden und in diesem Fall passiv geschaltet. Bei einem eingeschalteten Verstärker, d.h. bei einer Schalterposition, die den dritten Koppelpunkt 15 mit der Betriebsspannung U_{B} verbindet, wird das Signal das über die Leitung 1, den Filter 2, sowie die Kondensatoren 3 und 6 am Verstärker 7 anliegt, verstärkt und über die Kondensatoren 8 und 10, sowie das Filter 11 auf die Leitung 12 gegeben. Wenn durch das Steuersignal auf der Leitung 17 der Schalter 16 den Betriebsspannungseingang des Verstärkers auf das Bezugspotential legt, wird der Verstärker abgeschaltet. Ohne zusätzliche Vorkehrungen würde der Verstärker für das hochfrequente Eingangssignal eine hochohmige Impedanz darstellen. Die vorgeschalteten und nachfolgenden Bauteile wären in ihrer Funktion beeinträchtigt. Bei abgeschaltetem Verstärker 7 liegt am ersten Koppelpunkt5 Bezugspotential an, da er über die Spule 14 gleichspannungsmäßig mit dem Koppelpunkt15 verbunden ist. Bei geeigneter Dimensionierung des Widerstands 13 fließt ein Gleichstrom von der Spannungsquelle U_{B} über den Widerstand 13 zum Knoten 9 und von dort weiter über die Diode 18 zum ersten Koppelpunkt5 und letztlich über die Spule 14 und den Schalter 16 zum Bezugspotential. Mit diesem Strom wird die Diode 18 in Durchlaßrichtung betrieben und sie weist dadurch eine niedrige Impedanz auf. Das Hochfrequenzsignal auf der Leitung 1 kann nun vom Filter 2 über die Diode 18 zum Filter 11 gelangen, allerdings nicht verstärkt, sondern durch die Diodenverluste leicht gedämpft. Diese Schaltung hat den zusätzlichen Vorteil, daß bei aktivem Diodenzweig ein aktiver Signalzweig mit bekannten und reproduzierbaren Signalübertragungseigeschaften geschaltet wird und daher die Signaldämpfung in diesem Fall nicht zufällig ist.

Bei eingeschaltetem Verstärker, also bei Verbindung des Knotenpunkts 15 mit der Betriebsspannung U_{B}, liegt dieses Gleichspannungspotential an allen drei Knotenpunkten 5, 9 und 15 gleichmäßig an. Da somit die Schwellenspannung der Diode 18 nicht erreicht wird, ist sie gesperrt und zeigt einen hohen Widerstand. Dadurch durchläuft das hochfrequente Signal der Leitung 1 den Diodenzweig nicht. Alle in der Schaltung vorhandene Kondensatoren dienen zur Entkopplung der hochfrequenten Signale von der Gleichspannungssteuerspannung. Als Filter beispielsweise in einer Empfangseinheit 102 ist das Filter 2 ein Duplexfilter, das Filter 11 z.B. ein angepaßtes Bandpaßfilter.

In einer weiteren Ausführungsform ist die Steuerung des Verstärkers 7 über einen zusätzlichen Eingangsanschluß möglich, an dem eine Steuerspannung anliegt. Weiterhin ist auch eine Ausführungsformm mit einer stromgesteuerten Umschaltung möglich.

## Patentansprüche

1. Schaltung für einen Verstärker, insbesondere für ein Funk-Sende/Empfänger (100), wobei der Verstärker (7) ein Hochfrequenzsignal verstärkt und einen Eingangsanschluß, einen Betriebsspannungsanschluß und einen Ausgangsanschluß aufweist, wobei der Verstärker (7) über den Betriebsspannungsanschluß in einen aktiven oder passiven Zustand schaltbar ist, **dadurch gekennzeichnet, daß** der Verstärker (7) über den Betriebsspannungsanschluß mit einem ersten Koppelpunkt (15) verbunden ist, an dem eine schaltbare Betriebsspannung anliegt, und daß mindestens eine parallel zum Verstärker (7) eingebaute Diode (18) eingangsseitig über einen zweiten Koppelpunkt (5) am Eingangsanschluß des Verstärkers (7) mit dem ersten Koppelpunkt (15) und ausgangsseitig über einen dritten Koppelpunkt (9) am Ausgangsanschluß des Verstärkers (7) mit der Betriebsspannung (15) verbunden ist und daß der zweite und dritte Koppelpunkt (5, 9) zwischen Kondensatoren (3, 6, 8, 10) liegt.

2. Schaltung für einen Verstärker nach Anspruch 1, **dadurch gekennzeichnet, daß** der Verstärker (7) bei Anliegen eines ersten Spannungswertes der Betriebsspannung am ersten Koppelpunkt (15) aktiv geschaltet ist und die Diode (18) sperrt und daß der Verstärker (7) bei Anliegen eines zweiten Spannungswertes am ersten Koppelpunkt (15) passiv und die Diode (18) auf Durchlaß geschaltet ist.

3. Schaltung für einen Verstärker nach Anspruch 1 oder 2, **dadurch gekennzeichnet, daß** vor oder nach der Diode (18) ein Widerstand (13) und vor oder nach der Diode eine Spule (14) eingebaut ist.

4. Schaltung für einen Verstärker nach Anspruch 1 bis 3, **dadurch gekennzeichnet, daß** Widerstand (13) und Spule (14) so gewählt sind, daß in Durchlaßrichtung der Diode (18) ein Gleichstrom zwischen Spannungsquelle der Betriebsspannung und dem Bezugspotential fließt.

5. Schaltung für einen Verstärker nach Anspruch 1 bis 4, **dadurch gekennzeichnet, daß** der Verstärker (7) einen zusätzlichen Steueranschluß aufweist.

6. Schaltung für einen Verstärker nach Anspruch 1 bis 5, **dadurch gekennzeichnet, daß** die Schaltung zur definierten Signaldämpfung des Hochfrequenzsignals auf Leitung (1) dient.

## Claims

1. Circuit for an amplifier, in particular for a radio transmitter/receiver (100), with the amplifier (7) amplifying a radio-frequency signal and having an input connection, an operating voltage connection and an output connection, with it being possible to switch the amplifier (7) to an active or passive state via the operating voltage connection, **characterized in that** the amplifier (7) is connected, via the operating voltage connection, to a first coupling point (15) to which a switchable operating voltage is applied, and **in that** the input of at least one diode (18) - which is fitted in parallel with the amplifier (7) - is connected to the first coupling point (15) via a second coupling point (5) at the input connection of the amplifier (7), and the output of said diode is connected to the operating voltage via a third coupling point (9) at the output connection of the amplifier (7), and **in that** the second and third coupling points (5, 9) are located between capacitors (3, 6, 8, 10).

2. Circuit for an amplifier according to Claim 1, **characterized in that**, when a first operating voltage value is applied to the first coupling point (15), the amplifier (7) is switched to be active and the diode (18) is reverse-biased, and **in that**, when a second voltage value is applied to the first coupling point (15), the amplifier (7) is switched to be passive and the diode (18) is forward-biased.

3. Circuit for an amplifier according to Claim 1 or 2, **characterized in that** a resistor (13) is fitted upstream or downstream of the diode (18) and a coil (14) is fitted upstream or downstream of the diode.

4. Circuit for an amplifier according to Claims 1 to 3, **characterized in that** the resistor (13) and coil (14) are selected in such a manner that, in the forward direction of the diode (18), a direct current flows between the operating voltage source and the reference-earth potential.

5. Circuit for an amplifier according to Claims 1 to 4, **characterized in that** the amplifier (7) has an additional control connection.

6. Circuit for an amplifier according to Claims 1 to 5, **characterized in that** the circuit is used for defined signal attenuation of the radio-frequency signal on line (1).

## Revendications

1. Circuit pour un amplificateur destiné notamment à un émetteur/récepteur radio (100), cet amplificateur (7) renforçant un signal à haute fréquence et présentant un raccord d'entrée, un raccord de sortie et un raccord de tension de service permettant la commutation de l'amplificateur (7) dans un état actif ou dans un état passif,
**caractérisé en ce que**
l'amplificateur (7) est relié par le raccord de tension de service à un premier point de couplage (15) auquel est appliqué une tension de service commutable, tandis qu'au moins une diode (18) montée en parallèle avec l'amplificateur (7) est reliée du côté entrée par un deuxième point de couplage (5) au premier point de couplage (15) et du côté sortie, à la tension de service par un troisième point de couplage (9) situé sur le raccord de sortie de l'amplificateur (7), le deuxième et le troisième point de couplage (5, 9) se trouvant entre des condensateurs (3, 6, 8, 10).

2. Circuit pour un amplificateur selon la revendication 1,
**caractérisé en ce que**
quand une première valeur de la tension de service est appliquée au premier point de couplage (15), l'amplificateur (7) fonctionne activement et la diode (18) bloque, tandis que quand une seconde valeur de la tension est appliquée au premier point de couplage (15), l'amplificateur est passif et la diode (18) est en position de passage.

3. Circuit pour un amplificateur selon la revendication 1 ou 2,
**caractérisé en ce que**
en amont ou en aval de la diode (18) est montée une résistance (13), et en amont ou en aval de la diode est montée une bobine (14).

4. Circuit pour un amplificateur selon une des revendications 1 à 3,
**caractérisé en ce que**
la résistance (13) et la bobine (14) sont choisies de manière que dans le sens de passage de la diode (18) un courant continu passe entre la source de la tension de service et le potentiel de référence.

5. Circuit pour un amplificateur selon une des revendications 1 à 4,
**caractérisé en ce que**
l'amplificateur (7) présente un raccord de commande supplémentaire.

6. Circuit pour un amplificateur selon une des revendications 1 à 5,
**caractérisé en ce que**
le circuit sert à amortir de manière définie le signal à haute fréquence sur le conducteur (1).
